# EUROPEAN PATENT SPECIFICATION

(11) **EP 0 683 602 B1**
(45) Date of publication and mention of the grant of the patent: **07.03.2001**
(21) Application number: 95104482.5
(22) Date of filing: 27.03.1995
(51) Int. Cl.: H04N 3/15

(54) **Method and apparatus for a low noise, charge coupled device**
Verfahren und Vorrichtung für eine rauscharme ladungsgekoppelte Anordnung
Procédé et appareillage pour un dispositif à couplage de charges à faible bruit

(30) Priority: 16.05.1994 US 242940
(43) Date of publication of application: 22.11.1995
(73) Proprietor: Agfa Corporation, Ridgefield Park, NJ 07660-2199 (US)
(72) Inventor: Pandelaers, Patrick M., Andover, MA 01810 (US); Buyze, Johan S., Lynnfield, MA 01940 (US)
(74) Representative: Van Ostaeyen, Marc Albert Jozef

(56) References cited:
- EP-A- 0 033 129
- EP-A- 0 115 225
- US-A- 3 986 198
- US-A- 4 620 231
- US-A- 4 912 560
- US-A- 5 055 667

## Description

The present invention relates to image sensing and scanning in general, and more particularly to control of a charge coupled device type of radiation sensor according to the preamble of claim 1.

Charge coupled devices are radiation sensors that are used to translate information such as graphic images and text into electrical signals. A scanned subject matter is exposed to radiation, usually in the form of light. The light reflects off of, or passes through, the scanned subject matter, and each of many sensors on a charge coupled device (CCD) detects the resulting levels of illumination. Electronic signals produced by the sensors are related to the intensity of the total incident radiation reflected or passed through the scanned subject matter. The electronic signals are used in the transmission, storage, or modification of the scanned information. Examples of devices in which charge coupled devices are used are the HORIZON, the HORIZON PLUS, and the SELECTSCAN document and transparency scanners manufactured by the Agfa Division of Miles Inc.. The SELECTSCAN uses a charge coupled device that has anti-blooming circuitry. Anti-blooming circuitry is built into a CCD of the type that is commercially available as the LORAL CCD 191 and the Kodak KLI8003, among others. The operation of such a CCD is described in many U.S. patents including U.S. 5,055,667 to Sayag.

A CCD contains an array of photosensors. Radiation in the form of light impinges on the photosensors of a CCD and charge is generated that is proportional to the light on each photosensor. The photon-generated electrons are transported via the photogate to the transfer gate, and via the transfer gate to the shift registers. The charge in the shift registers is shifted out and converted to an electrical output signal by a charge-to-voltage converter.

A problem that is well known in the art faces users of charge coupled devices. At very low radiation levels, the analog output is non-linear with respect to the radiation input. There are many reasons for this behavior, among which is Vertical Charge Transfer Loss and depletion of the photosensitive area. In high-precision applications, such non-linearity will complicate corrections made to compensate for non-uniformity of illumination of the array of sensors. This multiplicative type of correction, described in many patents including U.S. 4,748,515 to Van Daele and Pandelaers, is simple to implement if the charge coupled device behaves in a linear fashion. If the charge coupled device is non-linear, the correction can be very complex.

One solution to avoiding non-linearity that is well known in the prior art is the addition of an optical bias. An optical bias is an additional radiation source which contributes to the total incident radiation in the system. Such a bias insures that the level of incident radiation will always be above the level at which the CCD is non-linear, insuring that the CCD operates in a sufficiently linear portion of its characteristic. An optical bias involves photo-conversion in that photons are converted to electrons. Photo-conversion is a statistical process featuring a Poisson distribution, so the root-mean-squared (RMS) noise associated with an optical bias is the square root of the freed electrons. An optical bias can contribute a significant amount of noise to the system noise.

There are also thermal issues associated with keeping a constant optical bias level. In a CCD system, the maximum desired dark-level drift is 1/4 of the dark noise. Since the dynamic range can be described as the ratio of the dark noise to the saturation voltage, in a CCD system with a dynamic range of 1:15000 (dark noise normalized to 1) for example, the maximum allowable drift would be 1:60000. It is extremely difficult to operate a light emitting diode of the type that is usually used as an optical bias to within such a small drift without controlling the LED temperature. Temperature control of an LED adds complexity and expense to the system.

US-A-5,055,667 on which the preamble of claim 1 is based, describes a method of controlling the dynamic range of a CCD or a similar device. In this method a potential is applied to the control gate which is a magnitude causing all charge above a certain charge clipping level in the photogate region to pass the sink region and the magnitude of the potential is caused to vary during the exposure period according to a predetermined function. It however says nothing about how to avoid the non-linearity of the charge coupled devices at very low radiation levels.

It is an object of the present invention, therefore, to operate a charge coupled device in such a way as to avoid image artifacts such as streaking that would be apparent if a multiplicative correction algorithm was applied to a non-linear device.

This object is solved by a method having the features of claim 1.

The present invention allows to operate a charge coupled device in such a way as to avoid the need for complicated correction algorithms for illumination non-uniformity that would be otherwise necessary to avoid image artifacts.

Further, the present invention allows to operate a charge coupled device to avoid both image artifacts and the need for complicated correction algorithms without adding noise, complexity, or cost to the system.

A charge coupled device is voltage controlled so as to induce a small amount of bias charge in the photogate region. This charge serves to bias the device so that it operates in a linear fashion, especially when exposed to low radiation levels. Since the bias is produced electrically rather than optically, the noise level of the charge coupled device is reduced. The low radiation levels are offset to higher light levels which are in a more linear portion of the radiation response characteristic of the charge coupled device.

The objects and features of the invention will best be understood from a detailed description of a preferred embodiment thereof selected for the purposes of illustration and shown in the accompanying drawings.
- Fig. 1: is a timing diagram showing voltage and timing control to bias the charge coupled device of Fig. 2; and
- Fig. 2: is a schematic depicting a prior art charge coupled device.

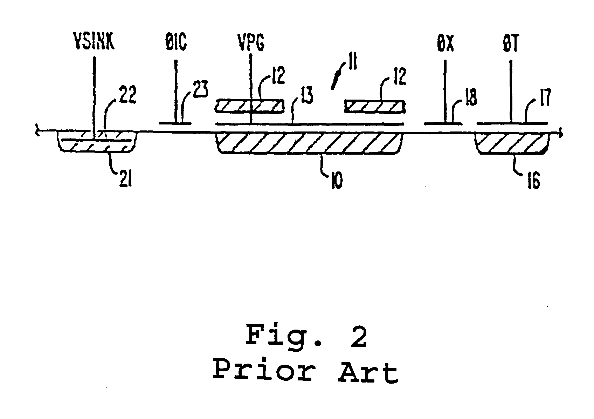

Fig. 2 is a schematic depicting a prior art charge coupled device (CCD). The structure of the CCD includes anti-blooming architecture. The device contains a photogate region 10 in which a photon generated charge accumulates. The charge is generated in the photogate region 10 by radiant energy impinging upon the photosite 11 limited by light shields 12. A photogate electrode 13 overlies the photogate region 10. An electrical potential V_{PG} is applied to photogate electrode 13, which maintains an electric field in the photogate region 10 that causes charge to accumulate in the region. The transport gate region 16 is adjacent to the photogate region 10. Charge packets accumulated in the photogate region 10 are repeatedly transferred to the transport gate region 16. The transport gate region 16 typically forms a part of a shift register or other transport structure for transporting the charge packet received from the photogate region to other circuit structures for processing. Overlying transport gate region 16 is transport gate electrode 17, to which an electrical potential ΦT is applied for enabling the accumulation of charge in the transport gate 16. A transfer gate electrode 18 is disposed between photogate region 10 and transport gate 16. The passage of a charge packet from photogate region 10 to transport gate 16 is determined by the electrical potential ΦX applied to transfer gate electrode 18.

Adjacent to photogate region 10, on an opposite side from the transport gate 16 is the anti-blooming architecture, including the sink region 21. Sink region 21 is attached to an electrode 22 to which an electrical potential V_{SINK} is applied to define the potential well for receiving excess charge. An integration control gate 23 is between photogate region 10 and sink region 21. In anti-blooming operation, the electrical potential applied to the integration control gate 23, Φ_{IC} is used to control flow of excess charge to the sink.

In the present invention, the sink 21 is used as the source for a bias charge to bias the photogate 10. The sink 21 is controlled to act both as an electron source and as a sink. The integration control 23 that in anti-blooming operation is used to control flow of excess charge from the photogate 10 to the sink 21 also is used to control the flow of charge from the sink 21 to the photogate 10.

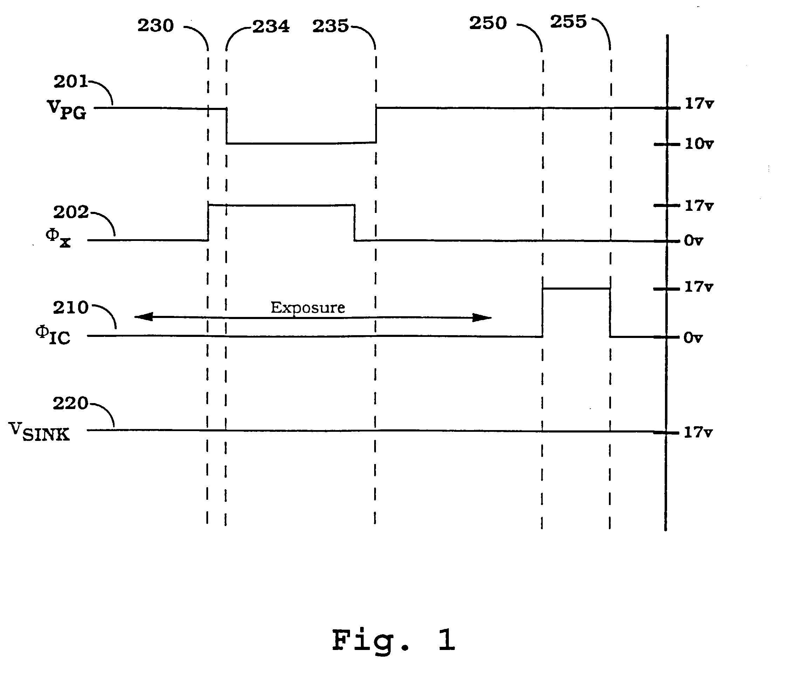

Fig. 1 is a timing diagram showing voltage and timing control to bias the charge coupled device of Fig. 2. Fig. 1 plots voltage vs. time for the electrical potentials (i.e. control voltages) V_{PG} 201, Φ_{X} 202, Φ_{IC} 210, and V_{SINK} 220.

The photogate region is biased electrically by controlling the amplitude of the photogate control voltage V_{PG} 201 during the time that charge is not being transferred out of the photogate region for readout. In Fig. 1 this non-transfer time is shown as the time before 230 and after 235. In prior art operation V_{PG} would be set below the level at which bias charge is induced during the non-transfer time before 230 and after 235. Prior art has stayed away from increasing the photogate control voltage higher than the level at which bias charge is induced exactly because a bias charge causes an offset in the device output signal. CCD's however demonstrate nonuniformities and offsets at the output when not exposed to any radiation. This is called the dark signal which is different for every single sensor. In professional CCD applications, it is common to correct for all dark signal uniformities and offsets so inducing an extra offset as a consequence of biasing does not cause any extra effort. In the present invention, a small amount of bias charge is used to avoid non-linear CCD response, especially at low radiation levels. The voltage control V_{PG} is set to a level which will induce enough bias charge to bias the CCD such that it operates in a linear portion of its characteristic. In Fig. 1, V_{PG} is shown to be 10 volts during the low time 234 - 235. In practice, we have found various voltages in the range of 8.5 - 15 volts to work well, depending on the particular CCD device.

The integration control voltage control Φ_{IC} 210 is the voltage applied to the integration control gate 23. Φ_{IC} is used to control the actual exposure time. When Φ_{IC} is set to a low voltage level, the sink region 21 is isolated, and photon-generated charge will accumulate in the photogate region. When Φ_{IC} 210 is set to a high level at time 250, the sink region 21 is no longer isolated from the photogate region. If V_{SINK} 220 is set to a high voltage such as the 17 volts shown in Fig. 1, during the transition as Φ_{IC} 210 is set to a high level, the sink 21 will act as a source and inject charge into the photogate region 10. The actual amount of charge transfer is controlled by the voltage differences between V_{PG}, V_{SINK} and Φ_{IC}.

In a very short time (sub-nanoseconds) after the charge transfer from the sink 21 to the photogate region 10 begins, an electrical equilibrium is reached between the sink region 21 and the photogate region 10 thereby establishing a bias charge in the photogate region. In the time after the equilibrium is established (250), and before the time Φ_{IC} is lowered (255), any charge generated in the photogate region by photo-conversion disturbs the equilibrium, and the excess charge moves from the photogate region 10 to the sink region. When Φ_{IC} is lowered at time 255, the equilibrium charge remains in the photogate region. Therefore integration can start since the sink region is again isolated from the photogate region.

The prior art has taught away from the present invention because the electrical bias, as described here, is temperature dependent. A system is best able to use an electrical bias if the temperature of the CCD is held stable. In high end scanning systems, the temperature of the CCD device is held stable and low to reduce output signal drift and dark noise. Thermal control insures that constant control voltage levels will produce a stable bias that will not change over time. Since the thermal control is already part of the system, the electrical bias has the additional benefit of being much less complex and less expensive to implement than an additional thermal control that would be necessary to control the temperature of an optical bias source.

An electrical bias is far superior than the prior art optical bias in that there is greatly reduced noise. An electrical bias does not involve a statistical process, and has a noise level that is an order of magnitude less than that of an optical bias.

We have found that approximately 1% of the saturation charge level as an electrical bias will operate the LORAL CCD 191 in a sufficiently linear portion of its characteristic. In the present implementation of the invention, V_{PG} 201 is set to a value between 8.0 and 15.5 volts during the transfer time. The value can be different for each CCD. For the most accurate results, each scanning system can be calibrated for that specific device. The voltage V_{PG} 201 set is generally higher than the voltage recommended by the device manufacturers for normal operation, but not higher than the maximum rating specified by the device manufacturer.

In the embodiment shown in Fig. 1, the anti-blooming circuitry is not being used for anti-blooming, so the signal levels shown in Fig. 1 are acceptable without additional manipulation of V_{SINK} 220,, Φ_{IC} 210, or V_{PG} 201. It should be clear to one skilled in the art that use of the anti-blooming circuitry would require additional manipulation of these signals.

## Claims

1. A method of operating a charge coupled device having a radiation responsive photogate region (10), in which a photon generated charge accumulates and is read out, a photogate electrode (13) overlying the photogate region (10), said photogate electrode having an electrical potential of V_{PG} (201) applied thereto, and a sink region (21) connected to the photogate region (10) by an integration control gate (23), said method comprising the step of applying an electrical potential V_{SINK} (220) to the sink region (21) to define a potential well for receiving an excess charge from the photogate region (10),
characterized in that said method further comprises the step of, before accumulation of photon generated charge in the photogate region (10), applying an electrical potential ⌀_{IC} (210) to the integration control gate (23) so that the sink region (21) is used as a potential source for establishing a bias charge in the radiation responsive photogate region (10) sufficient to cause the charge coupled device to operate in a generally linear portion of its radiation response characteristic.

2. The method according to claim 1 further comprising the steps of
during establishing of bias charge in the photogate region (10)
a. setting V_{SINK}(220) to a high voltage; and
b. setting ⌀_{IC} (210) to a potential level which is sufficiently high to allow a bias charge to transfer from the sink region (21) to the radiation responsive photogate region (10).

3. The method according to claim 2 further comprising the step of
during establishing of bias charge in the photogate region (10)
setting V_{PG} (201) to a potential level which is high enough to attract a bias charge from the sink region (21) to the radiation responsive photogate (10).

## Patentansprüche

1. Verfahren zum Betrieb eines CCD-Elements mit einem strahlungsempfindlichen Photogate-Bereich (10), in dem sich eine durch Photonen erzeugte Ladung ansammelt und herausgelesen wird, einer Photogate-Elektrode (13), die über dem Photogate-Bereich (10) liegt, wobei an die Photogate-Elektrode ein elektrisches Potential V_{PG} (201) angelegt wird, und einem Senkenbereich (21), der durch ein Integrations-Steuergate (23) mit dem Photogate-Bereich (10) verbunden ist, wobei bei dem Verfahren ein elektrisches Potential V_{SINK} (220) an den Senkenbereich (21) angelegt wird, um eine Potentialmulde zur Aufnahme einer überschüssigen Ladung aus dem Photogate-Bereich (10) zu definieren, dadurch gekennzeichnet, daß bei dem Verfahren weiterhin vor der Ansammlung von durch Photonen erzeugter Ladung in dem Photogate-Bereich (10) ein elektrisches Potential ⌀_{IC} (210) an das Integrations-Steuergate (23) angelegt wird, so daß der Senkenbereich (21) als eine Potentialquelle zur Herstellung einer Vorladung in dem strahlungsempfindlichen Photogate-Bereich (10) verwendet wird, die ausreicht, um zu bewirken, daß das CCD-Element in einem im allgemeinen linearen Teil seiner Strahlungsansprechkennlinie betrieben wird.

2. Verfahren nach Anspruch 1, weiterhin mit den folgenden Schritten:
während des Herstellens von Vorladung in dem Photogate-Bereich (10)
a. Einstellen von V_{SINK} (220) auf eine hohe Spannung; und
b. Einstellen von ⌀_{IC} (210) auf einen Potentialwert, der hoch genug ist, um einen Transfer von Vorladung aus dem Senkenbereich (21) in den strahlungsempfindlichen Photogate-Bereich (10) zu ermöglichen.

3. Verfahren nach Anspruch 2, weiterhin mit dem folgenden Schritt:
während des Herstellens von Vorladung in dem Photogate-Bereich (10)
Einstellen von V_{PG} (201) auf einen Potentialwert, der hoch genug ist, um eine Vorladung aus dem Senkenbereich (21) in den strahlungsempfindlichen Photogate-Bereich (10) anzuziehen.

## Revendications

1. Procédé de fonctionnement d'un dispositif à couplage de charges doté d'une région de grille photonique (10) sensible au rayonnement, dans laquelle une charge créée par les photons s'accumule et est lue, d'une électrode (13) de grille photonique recouvrant la région de grille photonique (10), ladite électrode de grille photonique se voyant appliquer un potentiel électrique V_{PG} (201), et d'une région de récepteur (21) connectée à la région de grille photonique (10) par une grille de commande d'intégration (23), ledit procédé comprenant l'étape consistant à appliquer un potentiel électrique V_{RÉCEPTEUR} (220) sur la région de récepteur (21) en vue de définir un puits de potentiel pour recevoir une charge excédentaire issue de la région de grille photonique (10),
caractérisé en ce que ledit procédé comprend en outre l'étape consistant, avant l'accumulation de charge créée par les photons dans la région de grille photonique (10), à appliquer un potentiel électrique Φ_{IC} (210) sur la grille de commande d'intégration (23) de façon à utiliser la région de récepteur (21) comme source de potentiel pour établir une charge de polarisation dans la région de grille photonique (10) sensible au rayonnement, suffisante pour que le dispositif à couplage de charges fonctionne dans une partie généralement linéaire de sa courbe de réponse en rayonnement.

2. Procédé selon la revendication 1, comprenant en outre les étapes consistant, durant l'établissement de la charge de polarisation dans la région de grille photonique (10), à
a. fixer V_{RÉCEPTEUR} (220) à une tension élevée ; et
b. fixer Φ_{IC} (210) à un niveau de potentiel suffisamment élevé pour permettre le transfert d'une charge de polarisation de la région de récepteur (21) à la région de grille photonique (10) sensible au rayonnement.

3. Procédé selon la revendication 2, comprenant en outre l'étape consistant, durant l'établissement de la charge de polarisation dans la région de grille photonique (10), à
a. fixer V_{PG} (201) à un niveau de potentiel suffisamment élevé pour attirer une charge de polarisation de la région de récepteur (21) à la grille photonique (10) sensible au rayonnement.
